(19) Europäisches Patentamt
European Patent Office
Office européen des brevets

(11) Veröffentlichungsnummer: **0 006 627**
**B1**

(12) # EUROPÄISCHE PATENTSCHRIFT

(45) Veröffentlichungstag der Patentschrift: **18.05.83**

(51) Int. Cl.³: **G 03 F 7/10,** G 03 C 1/72, G 03 F 7/08

(21) Anmeldenummer: **79102169.4**

(22) Anmeldetag: **29.06.79**

(54) **Strahlungsempfindliches Gemisch und Verfahren zur Herstellung von Reliefbildern.**

(30) Priorität: **05.07.78 DE 2829511**

(43) Veröffentlichungstag der Anmeldung: **09.01.80 Patentblatt 80/1**

(45) Bekanntmachung des Hinweises auf die Patenterteilung: **18.05.83 Patentblatt 83/20**

(84) Benannte Vertragsstaaten: **BE CH DE FR GB IT NL SE**

(56) Entgegenhaltungen:
**DE - A - 2 610 842**
**DE - A - 2 618 276**
**DE - A - 2 718 254**
**US - A - 3 779 778**

(73) Patentinhaber: **HOECHST AKTIENGESELLSCHAFT**
**Postfach 80 03 20**
**D-6230 Frankfurt/Main 80 (DE)**

(72) Erfinder: **Sander, Jürgen, Dr.**
**Berliner Ring 27**
**D-6233 Kelkheim/Ts. (DE)**
Erfinder: **Skaletz, Detlef, Dr.**
**Am Taubertsberg 4**
**D-6500 Mainz (DE)**
Erfinder: **Buhr, Gerhard, Dr.**
**Am Erdbeerstein 28**
**D-6240 Königstein/Ts. (DE)**
Erfinder: **Lohaus, Gerhard, Dr.**
**Uhlandstrasse 4**
**D-6233 Kelkheim/Ts. (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

EP 0 006 627 B1

Strahlungsempfindliches Gemisch und Verfahren zur Herstellung von Reliefbildern

Die Erfindung betrifft ein neues strahlungsempfindliches Gemisch, das als wesentliche Bestandteile (a) eine Verbindung, die unter Einwirkung von aktinischer Strahlung eine Säure bildet, und (b) eine Verbindung enthält, die wenigstens eine durch Säure spaltbare C—O—C-Gruppe aufweist.

Positive arbeitende lichtempfindliche Kopiermaterialien, d. h. Materialien, deren Kopierschicht an den belichteten Stellen löslich wird, sind bekannt. Es haben sich vor allem die positiv arbeitenden Kopiermaterialien auf der Basis von o-Chinondiaziden in der Praxis durchgesetzt.

Die Lichtempfindlichkeit dieser Kopiermaterialien befriedigt häufig nicht. Eine Steigerung der Lichtempfindlichkeit kann man durch Verwendung katalytisch wirksamer lichtempfindlicher Systeme erreichen, da hierbei die Quantenausbeute größer als 1 wird. So wurde das bekannte Prinzip, durch photolytisch erzeugte Säuren Folgereaktionen auszulösen und dadurch ein Löslichwerden der belichteten Stellen zu erreichen, in neuerer Zeit für positiv arbeitende Systeme genutzt. Dabei dienen photochemisch erzeugte starke Säuren zur Spaltung von speziellen neider- und hochmolekularen Acetalen und O,N-Acetalen, die als Hydroxyl- oder Amin-Komponenten aromatische Verbindungen enthalten (US—PS 3 779 778), und von Orthoestern und Amidacetalen (DT—OS 2 610 842).

Auch die Kombination von photochemischen Säurebildnern mit bestimmten Polyaldehyden und Polyketonen ist als positiv arbeitende Kopiermasse beschrieben worden, die bei Belichtung sichtbare Bilder liefert (US—PS 3 915 704, 3 915 706, 3 917 483, 3 932 514 und 2 892 712).

Diese Stoffgemische sind jedoch nicht frei von Nachteilen. Polyaldehyde und Polyketone, welche als wesentliche Bestandteile die Qualität der entsprechenden Aufzeichnungsmaterialien bestimmen, können in ihren stofflichen Eigenschaften nur begrenzt varriert und den praktischen Erfordernissen angepaßt werden.

Trotz der katalytischen Arbeitsweise besitzen die Kopiermassen, die die oben genannten Acetale und O,N-Acetale enthalten, keine befriedigende praktische Lichtempfindlichkeit. Außerdem sind viele der erwähnten Acetale, O,N-Acetale und Orthoester nicht leicht zugänglich.

In der älteren Anmeldung P 27 18 254 ist ferner ein strahlungsempfindliches Gemisch aus photolytischen Säurespendern und bestimmten aliphatischen Polyacetalen beschrieben, das ebenfalls positiv arbeitet.

Aufgabe der Erfindung war es, ein neues, positiv arbeitendes, strahlungsempfindliches Gemisch vorzuschlagen, das eine hohe Empfindlichkeit für aktinische Strahlung, insbesondere kurzwelliges Licht und Elektronenstrahlung, besitzt und dessen Bestandteile leicht zugänglich sind.

Die Erfindung geht aus von einem Strahlungsempfindlichen Gemisch, das (a) eine unter Einwirkung von aktinischer Strahlung Säure bildende Verbindung und (b) eine Verbindung enthält, die mindestens eine durch Säure spaltbare C—O—C-Gruppe aufweist und deren Löslichkeit in einem flüssigen Entwickler durch Einwirkung von Säure erhöht wird.

Das erfindungsgemäße Gemisch ist dadurch gekennzeichnet, daß die durch Säure spaltbare Verbindung als säurespaltbare Gruppe wenigstens eine Enoläthergruppe enthält.

Als aktinische Strahlung soll im Rahmen dieser Beschreibung jede Strahlung verstanden werden, deren Energie mindestens der des kurzwelligen sichtbaren Lichts entspricht. Geeignet ist insbesondere langwellige UV-Strahlung, aber auch Elektronen- und Laserstrahlung.

Als flüssige Entwickler sind insbesondere wäßrige Lösungen, vorzugsweise schwach alkalische Lösungen, aber auch organische Lösungsmittel, ggf. im Gemisch mit Wasser oder wäßrigen Lösungen, zu verstehen.

Von den durch Säure spaltbaren Verbindungen, die wenigstens eine Enoläthergruppe enthalten, werden diejenigen bevorzugt, die der allgemeinen Formel I

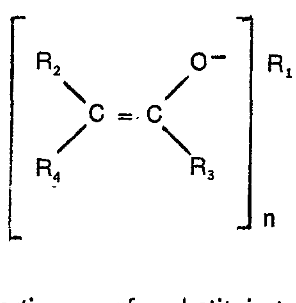

(I)

entsprechen, worin $R_1$ einen n-wertigen, ggf. substituierten aliphatischen Rest mit wenigstens 2 Kohlenstoffatomen bedeutet, $R_2$, $R_3$ und $R_4$ gleich oder verschieden sind und Wasserstoffatome, Alkyl- oder Arylreste bedeuten oder jeweils zu zweit zu einem ggf. substituierten gesättigten oder olefinisch ungesättigten Ring verbunden sind, und n eine Zahl von 1 bis 4, vorzugsweise 1 oder 2, insbesondere 2, ist.

Dabei sind unter Arylresten vorzugsweise ein- oder mehrkernige, ggf. durch Alkyl-, Aryl-, Alkoxy-, Aryloxy-, Acyl- Acyloxy-, Alkylmercapto-, Aminoacyl-, Acylamino-, Carbalkoxy-, Halogen-, Nitro-,

Sulfonyl- oder Cyangruppen substituierte aromatische oder heteroaromatische Reste, die im allgemeinen 4 bis 20 C-Atome enthalten, zu verstehen. Bevorzugt werden einkernige aromatische Reste mit 6 bis 10 Kohlenstoffatomen.

Wenn $R_2$, $R_3$ oder $R_4$ Alkylreste bedeuten, können diese gesättigt oder ungesättigt, ketten- oder ringförmig sein und ggf. durch Halogenatome, Cyan-, Ester-, Hydroxy-, Alkoxy-, Aryloxy- oder Arylreste substituiert sein.

$R_2$, $R_3$ und $R_4$ haben als Einzelsubstituenten im allgemeinen 1 bis 15, vorzugsweise 1 bis 8, Kohlenstoffatome.

Wenn zwei der Reste $R_2$, $R_3$ und $R_4$ zusammen einen Cycloalkyloder Cycloalkenylrest bilden, kann dieser im allgemeinen 3 bis 8, vorzugsweise 5 oder 6, Ringglieder haben. Bevorzugt werden auch Verbindungen dieses Typs, in denen dieser Ring mit einem aromatischen oder cycloaliphatischen Ring durch Annellierung verbunden ist. Das Ringsystem kann durch Reste der oben angegebenen Art substituiert sein. Es kann allgemein 4 bis 20, vorzugsweise 5 bis 15, Kohlenstoffatome enthalten.

Außer den angegebenen Substituenten kann auch eine weitere Gruppierung der Formel I als Substituent in einem der Reste $R_2$, $R_3$ und $R_4$ vorkommen.

Als n-wertige aliphatische Reste $R_1$ kommen verzweigte und unverzweigte, gesättigte und ungesättigte, cyclische und kettenförmige in Betracht, die durch ggf. substituierte Arylreste, Halogenatome, Cyan-, Ester-, Aryloxy-, Hydroxy- oder Alkoxygruppen substituiert sein und Äther-, Thioäther- oder Ketogruppen enthalten können.

$R_1$ hat im allgemeinen 2 bis 30, vorzugsweise 2 bis 15 Kohlenstoffatome. Wenn $n = 1$ ist, sollte $R_1$ bevorzugt mindestens 6 Kohlenstoffatome haben.

Eine besondere Gruppe von Verbindungen der allgemeinen Formel I sind Verbindungen der Formel II

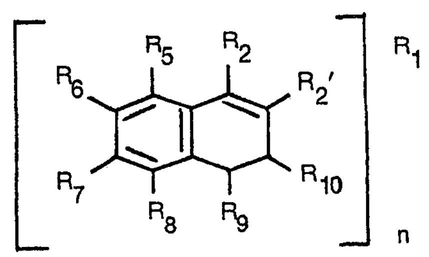

(II)

Darin haben $R_1$ und n die gleiche Bedeutung wie in Formel I.

$R_2$ und $R_2'$ sind voneinander verschieden, wobei der eine Rest die Gruppe —O— und der andere ein Wasserstoffatom, einen Alkyl- oder Arylrest bedeutet, und $R_5$ bis $R_{10}$ sind gleich oder verschieden und bedeuten Wasserstoff- oder Halogenatome, Alkyl-, Aryl- oder Alkoxyreste.

Die säurespaltbaren Verbindungen kann man allgemein durch Umsetzung von n Molen Carbonylverbindung (Keton oder Aldehyd) der Formel

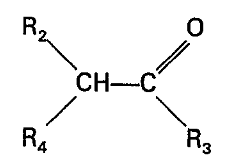

oder n Molen der von diesen Carbonylverbindungen abgeleiteten Enoläther der Formel

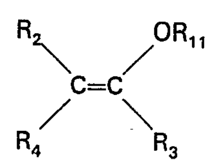

mit 1 Mol eines Alkohols der Formel $R_1(OH)_n$ erhalten. Dabei haben n und $R_1$ bis $R_4$ die oben angegebene Bedeutung; $R_{11}$ bedeutet einen Alkylrest mit 1 bis 6 C-Atomen, insbesondere einen Methyl- oder Äthylrest.

Die Umwandlung der oben angegebenen Carbonylverbindungen in die als ihre synthetischen Äquivalente aufzufassenden Enoläther der oben angegebenen Formel ist nach bekannten Methoden, z. B. durch Umsetzung mit Orthocarbonsäureestern, leicht möglich.

Unter n-wertigen aliphatischen Alkoholen sind in dieser Beschreibung Alkohole zu verstehen, deren alkoholische OH— Gruppen alle an verschiedenen gesättigten aliphatischen oder cycloaliphatischen C-Atomen stehen.

Beispiele für Carbonylverbindungen, aus denen bzw. aus deren niederen Enolmonoalkyläthern die

säurespaltbaren Enoläther der Formel I hergestellt werden können, sind 1- und 2-Tetralon, 1-Benzosuberon, Chromanon-4, Thiochromanon-4, 2,2-Dimethylthiochromanon-4, 2-Methyl-thiochromanon-4, 1-Methyl-2-, 2-Methyl-1-, 4-Methyl-1-, 5-Methoxy-1-, 5-Methoxy-2-, 6-Methoxy-2-, 6-Methoxy-1-, 7-Methoxy-1-, 7-Methoxy-2- und 4-Phenyl-1-tetralon, 4,5,6,7-Tetrahydro-4-oxo-thionaphthen, 4,5,6,7-Tetrahydro-4-oxo-benzofuran und 6-Methyl- bzw. 6,6-Dimethyl-4,5,6,7-tetrahydro-4-oxo-benzofuran, n-Pentanal, 2- und 3-Methyl-pentanal, 9-Fluorenaldehyd, Phenyl- und Diphenylacetaldehyd, Phenoxyacetaldehyd, 2-Phenyl- und 3-Phenyl-propionaldehyd, n-Hexanal, 2- und 3-Äthyl-butanal, 4-Methyl-pentanal, Cyclopentancarbaldehyd, n-Heptanal, Cyclohexancarbaldehyd, 1,2,3,6-Tetrahydro-benzaldehyd, 3-Äthyl-pentanal, 3- und 4-Methyl-hexanal, n-Octanal, 2- und 4-Äthyl-hexanal, 3,5,5-Trimethyl-hexanal, 4-Methyl-heptanal, 3-Äthyl-n-heptanal, Decanal, das Monohydroformylierungsprodukt von Dicyclopentadien, Dodecanal, Phenylaceton, 1,3-Diphenyl-aceton, 2,2-Diphenyl-aceton, Benzylaceton, Butan-2-on, Benzylpropylketon, Äthylbenzylketon, Benzylmethylketon, 5-Methyl-hexan-2-on, 2-Methyl-pentan-2-on, 2-Methyl-pentan-3-on, Hexan-2-on, Hexan-3-on, Pentan-3-on, 2-Methyl-butan-3-on, 2,2-Dimethyl-butan-3-on, 5-Methyl-heptan-3-on, Octan-3-on, Octan-4-on, Octan-2-on, Nonan-2-on, Nonan-3-on, Nonan-5-on, Heptan-2-on, Heptan-3-on, Heptan-4-on, Undecan-5-on, Undecan-6-on, Dodecan-2-on, Dodecan-3-on, Dinonylketon, Undecan-4-on, Undecan-2-on, Tridecan-2-on, Tridecan-3-on, Dodecan-5-on, Dioctylketon, 2-Methyl-octan-3-on, Decan-2-on, Decan-3-on, Decan-4-on, Methyl-$\alpha$-naphthylketon, Didecylketon, Diheptylketon, Dihexylketon, 3-Fluor-4-methoxy-acetophenon, Acetophenon, 4-Chlor-acetophenon, 2,5-Dichlor-acetophenon, 4-Brom-acetophenon, 2,4-Dimethyl-acetophenon, 2-, 3- und 4-Fluor-acetophenon, Desoxybenzoin, 2-, 3- und 4-Methoxy-acetophenon, 2-, 3- und 4-Methyl-acetophenon, Propiophenon, 2-Brom-propiophenon, 4-Fluor-propiophenon, 4-Methoxy-propiophenon, Butyrophenon, 4-Chlor-butyrophenon, Valerophenon, Cyclohexanon, 2-Phenyl-cyclohexanon, 2-, 3- und 4-Methyl-cyclohexanon, 2,6-Dimethyl-cyclohexanon, 4-t-Butyl-cyclohexanon.

Grundsätzlich können auch Di-aldehyde und Di-ketone bzw. deren synthetische Äquivalente in gleicher Weise umgesetzt werden, wobei Verbindungen mit zwei Gruppierungen der Formel I gebildet werden.

Geeignete n-wertige aliphatische Alkohole sind z. B.:

Benzylalkohol, 4-Methoxy-benzylalkohol, Äthylenglykolmonobutyläther, Diäthylenglykolmonohexyläther, Triäthylenglykolmonoläther, 2-Phenoxy-phenoxy-propanol, 2-Äthyl-hexanol, 2-Äthylbutanol, 1- und 2-Phenyl-äthanol, Octanol, Decanol, Dodecanol, Äthylenglykolmonophenyläther, Äthylenglykol, Propan-1,2-diol, 3-Chlor-propan-1,2-diol, Propan-1,3-diol, n-Butan-1,3-diol, n-Butan-2,3-diol, 2-Methyl-n-pentan-2,4-diol, 2,3-Dimethyl-n-butan-2,3-diol, 3-Methyl-pentan-2,4-diol, 2-Äthyl-hexan-1,3-diol, Cyclohexan-1,3-diol, Cyclohexan-1,2-diol, 2-Phenoxy-propan-1,3-diol, 2-Butoxyäthyl-propan-1,3-diol, 2,2-Dimethyl-propan-1,3-diol, 2,2-Diäthyl-propan-1,3-diol, 2-Äthyl-2-butyl-propan-1,3-diol, Butan-1,4-diol, 7-Phenyl-heptan-1,4-diol, n-Hexan-2,5-diol, Octan-2,5-diol, Nonan-3,6-diol, Pentan-1,5-diol, n-Hexan-1,6-diol, 2-Äthyl-hexan-1,6-diol, 2,3-Dimethyl-hexan-1,6-diol, Heptan-1,7-diol, Cyclohexan-1,4-diol, Nonan-1,7-diol, Nonan-1,9-diol, 3,6-Dimethyl-nonan-1,9-diol, Decan-1,10-diol, Dodecan-1,12-diol, 1,4-Bis-(hydroxy-methyl)-cyclohexan, 2-Äthyl-1,4-bis-(hydroxy-methyl)-cyclohexan, 2-Methyl-cyclohexan-1,4-diäthanol, 2-Methyl-cyclohexan-1,4-dipropanol, Thiodipropylenglykol, 3-Methyl-pentan-1,5-diol, Dibutylenglykol, Hydroxypivalinsäure-neopentylglykolester, 4,8-Bis-(hydroxymethyl)-tricyclodecan, n-Buten-(2)-1,4-diol, n-But-2-in-1,4-diol, n-Hex-3-in-2,5-diol, 1,4-Bis-(2-hydroxy-äthoxy)-butin-(2), p-Xylylenglykol, 2,5-Dimethyl-hex-3-in-2,5-diol, Bis-(2-hydroxy-äthyl)-sulfid, 2,2,4,4-Tetramethylcyclobutan-1,3-diol, Di-, Tri-, Tetra-, Penta- und Hexaäthylenglykol, Di- und Tripropylenglykol, Polyäthylenglykole mit dem mittleren Molgewicht 200, 300, 400 und 600, Glycerin, Butan-1,2,4-triol, Pentan-1,2,5-triol, Pentan-1,3,5-triol, Hexan-1,2,6-triol, 1,4,7-Trihydroxy-heptan, 2,2,5,5-Tetramethylolcyclopentanon und 2,2,6,6-Tetramethylol-cyclohexanon.

Die oben beschriebenen bevorzugten organischen Verbindungen der allgemeinen Formel I sind allgemein in einem einstufigen Verfahren durch Umsetzung von Ketonen bzw. Aldehyden oder ihren synthetischen Äquivalenten in Gegenwart saurer Katalysatoren, wie p-Toluolsulfonsäure, Schwefelsäure und saurer Ionenaustauscher, mit aliphatischen Alkoholen darstellbar.

Die Ketone und Aldehyde sowie die aliphatischen Alkohole sind käuflich oder nach bekannten Verfahren leicht zugänglich.

Durch Verwendung unterschiedlicher Enoläther bzw. ihrer Gemische lassen sich die stofflichen Eigenschaften der Aufzeichnungsmaterialien breit variieren.

Die verwendeten Enoläther können eine oder mehrere Enoläthergruppen enthalten je nach der Wertigkeit des Alkohols oder der Anzahl der Carbonylgruppen in der zugrundeliegenden Carbonylverbindung.

Die Enoläther der Formel I haben im allgemeinen Molgewichte im Bereich von etwa 250 bis 800. Eine gute Resistenz der unbelichteten Bereiche gegenüber den Entwicklern wird in der Regel durch Enoläther erzielt, die Molgewichte von 300 bis 600 haben.

Die hier beschriebene Darstellungsmethode ist eine besonders leicht zugängliche Methode zur Darstellung von Enoläthern der allgemeinen Formel I.

Verbindungen der allgemeinen Formel II können z. B. auch durch elektrochemische Reduktion von 2-Naphthyläthern hergestellt werden, wie es in der DE—OS 26 18 276 beschrieben ist.

Zur Herstellung der erfindungsgemäßen positiv arbeitenden strahlungsempfindlichen Gemische werden die beschriebenen Enoläther gemischt mit Substanzen, die photochemisch und bzw. oder durch Einwirkung von energiereichen Strahlen Säuren bilden. Der Mengenanteil der Enoläther an den nichtflüchtigen Bestandteilen des gesamten Gemischs kann dabei zwischen etwa 9 und 70, vorzugsweise zwischen 14 und 45 Gew.-%, liegen.

Vorzugsweise enthalten die Gemische ferner ein polymeres, bevorzugt wasserunlösliches Bindemittel, das in organischen Lösungsmitteln löslich ist. Da sich als Entwicklerflüssigkeiten für die belichteten Kopierschichten mit Vorteil wäßrig-alkalische Lösungen einsetzen lassen und diese im allgemeinen gegenüber Entwicklern auf Basis organischer Lösungsmittel vorgezogen werden, werden insbesondere solche Bindemittel bevorzugt, die in wäßrigen Alkalien löslich oder mindestens quellbar sind.

Die bei vielen Positiv-Kopiermaterialien bewährten Phenolharze, vor allem Novolake, haben sich auch bei den erfindungsgemäßen Gemischen als besonders brauchbar und vorteilhaft erwiesen. Sie fördern die starke Differenzierung zwischen den belichteten und unbelichteten Schichtpartien beim Entwickeln, besonders die höher kondensierten Harze mit substituierten Phenolen, z. B. Kresolen, als Formaldehyd-Kondensationspartner. Die Novolake können auch in bekannter Weise durch Umsetzung eines Teils ihrer Hydroxygruppen, z. B. mit Chloressigsäure, Isocyanaten, Epoxiden oder Carbonsäureanhydriden, modifiziert sein. Andere alkalilösliche Harze, wie Mischpolymerisate aus Maleinsäureanhydrid und Styrol, Vinylacetat und Crotonsäure, Methylmethacrylat und Methacrylsäure und dgl. sind ebenfalls als Bindemittel geeignet. Die Art und Menge der alkalilöslichen Harze kann je nach Anwendungszweck verschieden sein; bevorzugt sind Anteile am Gesamtfeststoff zwischen 30 und 90, besonders bevorzugt 55—85 Gew.-%. Zusätzlich können noch zahlreiche andere Harze mitverwendet werden, bevorzugt Vinylpolymerisate wie Polyvinylacetate; Polyacrylate, Polyvinyläther und Polyvinylpyrrolidone, die selbst durch Comonomere modifiziert sein können. Der günstigste Anteil an diesen Harzen richtet sich nach den anwendungstechnischen Erfordernissen und dem Einfluß auf die Entwicklungsbedingungen und beträgt im allgemeinen nicht mehr als 20% vom alkalilöslichen Harz. In geringen Mengen kann die lichtempfindliche Schicht für spezielle Erfordernisse wie Flexibilität, Haftung, Glanz etc. außerdem noch Substanzen wie Polyglykole, Cellulose-Derivate wie Äthylcellulose, Netzmittel, Farbstoffe und feinteilige Pigmente enthalten.

Als strahlungsempfindliche Komponenten, die beim Bestrahlen Säuren bilden bzw. abspalten, sind eine große Anzahl von bekannten Verbindungen und Mischungen, wie Diazonium-, Phosphonium-, Sulfonium- und Jodonium-Salze, Halogen-Verbindungen, Chinondiazidsulfochloride und Organometall-Organohalogen-Kombinationen geeignet.

An Diazonium-Salzen kommen die in der Diazotypie bekannten Verbindungen mit ausnutzbarer Absorption zwischen 300 und 600 nm in Frage. Einige erprobte und erfahrungsgemäß ausreichend lagerfähige Diazonium-Verbindungen sind in den Beispielen genannt; bevorzugt werden Verbindungen, die keine basischen Substituenten enthalten.

Die genannten Diazonium-, Phosphonium, Sulfonium- und Jodonium-Verbindungen werden in der Regel eingesetzt in Form ihrer in organischen Lösungsmitteln löslichen Salze, meist als Abscheidungsprodukt mit komplexen Säuren wie Borfluorwasserstoffsäure, Hexafluorphosphor-, Hexafluorantimon- und -arsensäure.

Es können aber auch Derivate der positiv arbeitenden o-Chinondiazide verwendet werden. Die Azidität der beim Belichten von o-Naphthochinondiaziden entstehenden Indencarbonsäuren reicht meist nur knapp für eine ausreichende bildmäßige Differenzierung aus. Bevorzugt wird aus dieser Gruppe das Naphthochinon-1,2-diazid-4-sulfochlorid, bei dessen Belichtung drei Säurefunktionen gebildet werden, so daß ein relativ großer Verstärkungsfaktor bei der Spaltung der Enoläther entsteht.

Grundsätzlich sind als halogenhaltige strahlungsempfindliche und Halogenwasserstoffsäure bildende Verbindungen alle auch als photochemische Radikalstarter bekannten organischen Halogenverbindungen, beispielsweise solche mit mehr als einem Halogenatom an einem Kohlenstoffatom oder einem aromatischen Ring, brauchbar, Beispiele sind in den US—PS 3 515 552, 3 536 489 und 3 779 778 und der DE—OS 2 243 621 beschrieben. Die Wirkung dieser halogenhaltigen Verbindungen kann auch für die erfindungsgemäßen Positiv-Kopierschichten durch an sich bekannte Sensibilisatoren spektral beeinflußt und gesteigert werden.

Geeignet sind ferner bestimmte substituierte Trichlormethylpyrone, wie sie in der DE—OS 2 610 842 beschrieben sind. Besondere Eignung weisen die in der älteren Patentanmeldung P 27 18 259 beschriebenen 2-Aryl-4,6-bis-trichlormethyl-s-triazine auf.

Beispiele für geeignete Starter sind: 4-(Di-n-propylamino)-benzoldiazoniumtetrafluoroborat, 4-p-Tolylmercapto-2,5-diäthoxy-benzoldiazoniumhexafluorophosphat und -tetrafluoroborat, Diphenylamin-4-diazoniumsulfat, 4-Methyl-6-trichlormethyl-2-pyron, 4-(3,4,5-Trimethoxy-styryl)-6-trichlormethyl-2-pyron, 4-(4-Methoxy-styryl)-6-(3,3,3-trichlor-propenyl)-2-pyron, 2-Trichlormethylbenzimidazol, 2-Tribrommethyl-chinolin, 2,4-Dimethyl-1-tribromacetyl-benzol, 3-Nitro-1-tribromacetyl-benzol, 4-Dibromacetyl-benzoesäure, 1,4-Bis-dibrommethyl-benzol, Tris-dibrommethyl-s-triazin, 2-(6-Methoxynaphth-2-yl)-, 2-(Naphth-1-yl)-, 2-(Naphth-2-yl)-, 2-(4-Äthoxyäthyl-naphth-1-yl)-, 2-(Benzopyran-3-yl)-, 2-(4-Methoxy-anthrac-1-yl)-, 2-(Phenanthr-9-yl)-4,6-bis-trichlormethyl-s-triazin und die in den Beispielen angeführten Verbindungen.

Die Menge des Starters kann je nach seiner chemischen Natur und der Zusammensetzung des Gemischs ebenfalls sehr verschieden sein. Günstige Ergebnisse werden erhalten mit etwa 0,1 bis 10 Gew.-%, bezogen auf den Gesamtfeststoff, bevorzugt sind 0,2 bis 5%. Besonders für Kopierschichten von Dicken über 10 $\mu$m empfiehlt es sich, relativ wenig Säurespender zu verwenden.

Schließlich können dem lichtempfindlichen Gemisch noch lösliche oder auch feinteilige dispergierbare Farbstoffe sowie je nach Anwendungszweck auch UV-Absorber zugesetzt werden. Die günstigsten Mengenverhältnisse der Komponenten lassen sich im Einzelfall durch Vorversuche leicht ermitteln.

Geeignete Lösungsmittel für das erfindungsgemäße Stoffgemisch sind Ketone, wie Methyläthylketon; chlorierte Kohlenwasserstoffe wie Trichloräthylen und 1,1,1-Trichloräthan, Alkohole wie n-Propanol, Äther wie Tetrahydrofuran, Alkoholäther wie Äthylenglykol-monoäthyläther und Ester wie Butylacetat. Es können auch Gemische verwendet werden, die zudem noch für spezielle Zwecke Lösungsmittel wie Acetonitril, Dioxan oder Dimethylformamid enthalten können. Prinzipiell sind alle Lösungsmittel verwendbar, die mit den Schichtkomponenten nicht irreversibel reagieren.

Die Wahl der Lösungsmittel ist jedoch auf das vorgesehene Beschichtungsverfahren, die Schichtdicke und die Trocknungsvorrichtung abzustimmen. Dünne Schichten bis ca. 5 $\mu$m werden für Versuchsmengen vorzugsweise auf der Schleuder durch Aufgießen aufgetragen. Mit Lösungen bis zu ca. 40% Feststoffgehalt sind so mit einmaligem Auftrag oder mit einer Streichrakel Schichtdicken von mehr als 60 $\mu$m erreichbar. Für beidseitige Beschichtung wird Tauchbeschichtung vorgezogen, wobei durch Verwendung von niedrig siedenden Lösungsmitteln schnelles Antrocknen von Vorteil ist. Bandbeschichtung erfolgt durch Antragen mittels Walzen, Breitschlitzdüsen oder Sprühen; Einzelplatten wie Zink- und Mehrmetall-Platten können durch Gießer-Antrag (curtain-coater) beschichtet werden.

Im Vergleich zu anderen Positiv-Schichten, besonders denen auf o-Naphthochinondiazid-Basis, ist die Herstellung dickerer Schichten vorteilhaft möglich, da die Lichtempfindlichkeit des erfindungsgemäßen lichtempfindlichen Gemischs verhältnismäßig wenig dickenabhängig ist. Belichtung und Verarbeitung von Schichtdicken bis ca. 100 $\mu$m und darüber ist möglich.

Bevorzugte Träger für dicke Schichten über 10 $\mu$m sind Kunststoffolien, die dann als temporäre Träger für Transferschichten dienen. Dafür und für Farbfolien werden Polyesterfolien, z. B. aus Polyäthylenterephthalat, bevorzugt. Polyolefinfolien wie Polypropylen sind jedoch ebenfalls geeignet. Als Schichtträger für Schichtdicken unter ca. 10 $\mu$m werden meist Metalle verwendet. Für Offsetdruckplatten können eingesetzt werden: mechanisch oder elektrochemisch aufgerauhtes und ggf. anodisiertes Aluminium, das zudem noch chemisch, z.B. mit Polyvinylphosphonsäure, Silikaten oder Phosphaten, vorbehandelt sein kann, außerdem Mehrmetallplatten mit Cu/Cr oder Messing/Cr als oberste Schicht. Für Hochdruckplatten können die erfindungsgemäßen Schichten auf Zink- oder Magnesium-Platten sowie deren handelsübliche mikrokristalline Legierungen für Einstufenätzverfahren aufgetragen werden, außerdem auf ätzbare Kunststoffe wie Polyoxymethylen. Für Tiefdruck- oder Siebdruckformen eignen sich die erfindungsgemäßen Schichten durch ihre gute Haftung und Ätzfestigkeit auf Kupfer- bzw. Nickel-Oberflächen. Ebenso lassen sich die erfindungsgemäßen Gemische als Photoresists beim Formteilätzen verwenden.

Schließlich kann die Beschichtung direkt oder durch Schichtübertragung vom temporären Träger erfolgen auf Leiterplatten-Materialien, die aus Isolierplatten mit ein- oder beidseitiger Kupfer-Auflage bestehen, auf Glas oder Keramik-Materialien, die ggf. haftvermittelnd vorbehandelt sind, und auf Silicium-Scheiben, für die in der Mikroelektronik schon Erfahrung mit Elektronenstrahl-Bebilderung vorliegt. Außerdem können Holz, Textilien und Oberflächen vieler Werkstoffe beschichtet werden, die vorteilhaft durch Projektion bebildert werden und resistent gegen die Einwirkung alkalischer Entwickler sind.

Für die Trocknung nach der Beschichtung können die üblichen Geräte und Bedingungen übernommen werden, Temperaturen um 100° C und kurzfristig bis 120° C werden ohne Einbuße an Strahlungsempfindlichkeit vertragen.

Zum Belichten können die üblichen Lichtquellen wie Röhrenlampen, Xenonimpulslampen, metallhalogendotierte Quecksilberdampf-Hochdrucklampen und Kohlebogenlampen verwendet werden. Darüber hinaus ist bei den lichtempfindlichen Enoläther-Schichten das Belichten in üblichen Projektions- und Vergrößerungs-Geräten unter dem Licht der Metallfadenlampen und Kontakt-Belichtung mit gewöhnlichen Glühbirnen möglich. Die Belichtung kann auch mit kohärentem Licht eines Lasers erfolgen. Geeignet für die Zwecke vorliegender Erfindung sind leistungsgerechte kurzwellige Laser, beispielsweise Argon-Laser, Krypton-Ionen-Laser, Farbstoff-Laser und Helium-Cadmium-Laser, die zwischen 300 und 600 nm emittieren. Der Laserstrahl wird mittels einer vorgegebenen programmierten Strich- und/oder Raster-Bewegung gesteuert.

Das Bestrahlen mit Elektronenstrahlen ist eine weitere Bebilderungsmöglichkeit. Elektronenstrahlen können das erfindungsgemäße Gemisch wie auch viele andere organische Materialien durchgreifend zersetzen und vernetzen, so daß ein negatives Bild entsteht, wenn die unbestrahlten Teile durch Lösungsmittel oder Belichten ohne Vorlage und Entwickeln entfernt werden. Bei geringerer Intensität und/oder höherer Schreibgeschwindigkeit des Elektronenstrahls bewirkt dagegen der Elektronenstrahl eine Differenzierung in Richtung höherer Löslichkeit, d. h. die bestrahlten Schichtpartien können vom Entwickler entfernt werden. Es wurde gefunden, daß die erfindungsgemäßen Schichten erheblich

elektronenstrahl-empfindlicher als übliche Naphthochinondiazid-Schichten sind und — wie in den Beispielen erläutert — ein breiter Bandbereich vergleichsweise geringer Energieeinwirkung von Elektronenstrahlen ausgenutzt werden kann. Die Wahl der günstigsten Bedingungen kann durch Vorversuche leicht ermittelt werden.

Die bildmäßig belichtete oder bestrahlte Schicht kann mit praktisch den gleichen Entwicklern wie für handelsübliche Naphthochinondiazid-Schichten und Kopierlacke entfernt werden bzw. die neuen Schichten können in ihren Kopierbedingungen vorteilhaft auf die bekannten Hilfsmittel wie Entwickler und programmierte Sprühentwicklungsgeräte abgestimmt werden. Die wäßrigen Entwicklerlösungen können z. B. Alkaliphosphate, -silikate oder -hydroxide und ferner Netzmittel sowie kleinere Anteile organischer Lösungsmittel enthalten. In bestimmten Fällen sind auch Lösungsmittel-Wasser-Gemische als Entwickler brauchbar. Die Wahl des günstigsten Entwicklers kann durch Versuche mit der jeweils verwendeten Schicht ermittelt werden. Bei Bedarf kann die Entwicklung mechanisch unterstützt werden. Zur Erhöhung der Widerstandsfähigkeit beim Druck sowie der Resistenz gegen Auswaschmittel, Korrekturmittel und durch UV-Licht härtbare Druckfarben können die entwickelten Platten kurze Zeit auf erhöhte Temperaturen erwärmt werden, wie es für Diazoschichten aus der britischen Patentschrift 1 154 749 bekannt ist.

Erfindungsgemäß wird auch ein Verfahren zur Herstellung von Reliefbildern vorgeschlagen, bei dem man ein strahlungsempfindliches Aufzeichnungsmaterial aus einem Träger und einer Aufzeichnungsschicht, die als wesentliche Bestandteile (a) eine Verbindung, die unter Einwirkung von aktinischer Strahlung Säure bildet, und (b) eine Verbindung enthält, die mindestens eine durch Säure spaltbare C—O—C-Gruppe aufweist und deren Löslichkeit in einem flüssigen Entwickler durch Einwirkung von Säure erhöht wird, bildmäßig mit aktinischer Strahlung in solcher Dosis bestrahlt, daß die Löslichkeit der Schicht in einem flüssigen Entwickler zunimmt, und die bestrahlten Schichtteile mittels eines Entwicklers entfernt. Das Verfahren ist dadurch gekennzeichnet, daß man eine Verbindung (b) verwendet, die als säurespaltbare Gruppe wenigstens eine Enolöthergruppe enthält.

Wenn das Verfahren mit Elektronenstrahlung durchgeführt wird, sind neben den bekannten für sichtbares und nahes UV-Licht empfindlichen photolytischen Säurespendern auch solche geeignet, deren Absorptionsbereiche im kürzer welligen Teil des elektromagnetischen Spektrums liegen und die damit gegenüber Tageslicht wenig empfindlich sind. Dies hat den Vorteil, daß man die Aufzeichnungsmaterialien ohne Lichtausschluß handhaben kann und daß die Materialien besser lagerfähig gemacht werden können.

Als Beispiele für derartige Starter sind Tribrommethyl-phenyl-sulfon, 2,2',4,4',6,6'-Hexabromdiphenylamin, Pentabromäthan, 2,3,4,5-Tetrachlor-anilin, Pentaerythrittetrabromid, Clophen-Harz W, d. h. ein Chlorterphenylharz, oder chlorierte Paraffine zu nennen.

Im folgenden werden Beispiele für die erfindungsgemäßen lichtempfindlichen Gemische angegeben. Dabei wird zunächst die Herstellung einer Anzahl neuer Enoläther beschrieben, die in erfindungsgemäßen Gemischen als säurespaltbare Verbindungen erprobt wurden. Sie wurden als Verbindungen 1 bis 36 durchnumeriert und kehren unter dieser Bezeichnung in den Anwendungsbeispielen wieder.

In den Beispielen stehen Gewichtsteile (Gt) und Volumteile (Vt) im Verhältnis von g zu ccm. Prozent- und Mengenverhältnisse sind, wenn nichts anderes angegeben ist, in Gewichtseinheiten zu verstehen.

### Allgemeine Vorschrift A

*Herstellung der in den Tabellen 1 bis 3 aufgeführten Verbindungen 1 bis 24*

1 Mol eines n-wertigen aliphatischen Alkohols wird mit n Molen Methyl- oder Äthyl-Enoläther in Gegenwart von 1—2 Gewichtsprozent eines sauren Katalysators, z. B. p-Toluol-sulfonsäure, 2—3 Stunden bei Raumtemperatur oder leicht erhöhter Temperatur gerührt. Das bei der Reaktion freiwerdende Methanol oder Äthanol wird im Wasserstrahlvakuum vollständig entfernt. Nach Zugabe von inertem Lösungsmittel und festem Natriumcarbonat wird das Reaktionsgemisch filtriert und vom Lösungsmittel befreit. Das nach dem Entfernen leichtflüchtiger Bestandteile im Hochvakuum bei 100—150° C zurückbleibende Öl weist im IR-Spektrum keine Hydroxylbande auf. Zur Charakterisierung sind die Signale der vinylischen Protonen im NMR-Spektrum, die Enolätherbanden im IR-Spektrum und die Molpeaks im Massenspektrum angegeben.

Ebenso gelingt die Herstellung von vielen der aufgeführten Verbindungen, wenn man den freiwerdenden Alkohol unter Normaldruck abdestilliert.

TABELLE 1

Verbindungen der allgemeinen Formel I
$n = 2$; $R_2 = H$

| Verbindung Nr. | $R_1$ | 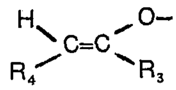 | NMR Vinylprotonen δ (ppm) ($CDCl_3$) | IR ($cm^{-1}$) ($CH_2Cl_2$) | MS ($M^+$) | Ausbeute (% d.Th.) |
|---|---|---|---|---|---|---|
| 1 | $(-CH_2)_2-O-(CH_2-)_2$ | 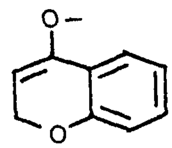 | 4,80 | 1 645 | 366 | 51 |
| 2 | $(-CH_2)_2(-OCH_2CH_2)_2-$ | 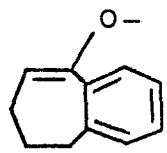 | 5,14 | 1 630 | 434 | 73 |
| 3 | $-(CH_2-)_5$ | wie 2 | 5,18 | 1 630 | 388 | 46 |
| 4 | $(-CH_2)_2-O-(CH_2-)_2$ | 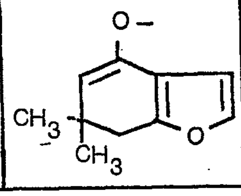 | – | 1 630 | 398 | 25 |

TABELLE 2

Verbindungen der allgemeinen Formel II
($R_6=R_7=R_8=R_9=R_{10}=H$); $R_2 \neq O-$

| Verbindung Nr. | n | $R_1$ | $R_2$ | $R_5$ | NMR Vinyl-protonen δ (ppm) ($CDCl_3$) | IR ($cm^{-1}$) ($CH_2Cl_2$) | MS (M+) | Ausbeute (% d.Th.) |
|---|---|---|---|---|---|---|---|---|
| 5 | 2 | $(-CH_2)_2(-OCH_2CH_2)_3-$ | H | H | 5,52 | 1 635 | 450 | 48 |
| 6 | 3 | 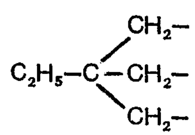 | H | H | 5,65 | 1 635 | 518 | 64*) |
| 7 | 1 | $(-CH_2)_2-O-(CH_2-)_2O-(CH_2-)_5CH_3$ | H | H | 5,59 | 1 635 | 318 | 75 |
| 8 | 2 | $(-CH_2)_2(-OCH_2CH_2)_2-$ | $CH_3$ | H | – | 1 645 | 434 | 52 |
| 9 | 2 | $(-CH_2)_2(-OCH_2CH_2)_2-$ | H | $CH_3O$ | 5,88 | 1 635 | 466 | 74 |
| 10 | 2 | p-Xylylen | H | H | 5,63 | 1 635 | 394 | 48 |

Bei den mit *) gekennzeichneten Verbindungen sind auch cyclische Ketale entstanden.

TABELLE 3

Verbindungen der allgemeinen Formel II
($R_2'=R_5=R_6=R_7=R_8=R_9=R_{10}=H$); $R_2$= O–

| Verbindung Nr. | n | $R_1$ | NMR Vinylprotonen δ (ppm) ($CDCl_3$) | IR ($cm^{-1}$) ($CH_2Cl_2$) | MS ($M^+$) | Ausbeute (% d.Th.) |
|---|---|---|---|---|---|---|
| 11 | 2 | $-(CH_2-)_5$ | 4,99 | 1 630 | 360 | 83 |
| 12 | 2 | $-(CH_2-)_4$ | 4,96 | 1 635 | 346 | 34 |
| 13 | 2 | $-(CH_2-)_3$ | 5,00 | 1 635 | 332 | 32*) |
| 14 | 2 | $-(CH_2-)_2$ | 4,99 | 1 635 | 318 | 30*) |
| 15 | 1 | $(-CH_2)_2(-OCH_2CH_2)_3-C_2H_5$ | 4,96 | 1 635 | 334 | 45 |
| 16 | 1 | Phenoxyäthyl | 5,02 | 1 635 | 266 | 51 |
| 17 | 1 | $(-CH_2)_{11}-CH_3$ | 4,95 | 1 635 | 314 | 59 |
| 18 | 1 | $(-CH_2)_2(-OCH_2CH_2)_2$-n-$C_4H_9$ | 4,96 | 1 635 | 318 | 40 |
| 19 | 2 | $-(CH_2-)_{10}$ | 4,94 | 1 635 | 430 | 84 |
| 20 | 2 | 1,4-Dimethyl-cyclohex-7,8-ylen | 4,95 | 1 630 | 400 | 79 |
| 21 | 2 | 1,4-Cyclohexylen | 5,05 | 1 630 | 372 | 62 |
| 22 | 2 | 4,8-Dimethyl-tricyclo-[4.3.1.0]-dec-11,12-ylen | 4,96 | 1 635 | 452 | 94 |
| 23 | 2 | 2,2-Diäthyl-1,3-propylen | 5,04 | 1 635 | 388 | 67 |
| 24 | 3 | $-CH_2-CH-(CH_2-)_4$ | 4,94 | 1 635 | 518 | 81*) |

Bei den mit *) gekennzeichneten Verbindungen sind auch cyclische Ketale entstanden.

Allgemeine Vorschrift B

*Herstellung der in den Tabellen 4 und 5 aufgeführten Verbindungen 25 bis 33*

1 Mol eines n-wertigen aliphatischen Alkohols wird mit n Molen Keton bzw. Aldehyd in Gegenwart von 1 bis 2 Gewichtsprozent eines sauren Katalysators, z. B. eines sauren Ionenaustauschers, in einem unter den Reaktionsbedingungen inerten, mit Wasser ein azeotropes Gemisch bildenden Lösungsmittel, z. B. Benzol, Toluol, Xylol, Chloroform oder Methylenchlorid, unter Rückfluß zum Sieden erhitzt, bis sich kein Reaktionswasser mehr abscheidet. Nach Neutralisation, z. B. mit Natriumcarbonat, wird das Reaktionsgemisch filtriert und vom Lösungsmittel befreit. Das nach dem Entfernen leichtflüchtiger Bestandteile im Hochvakuum bei 100 bis 150°C zurückbleibende Öl weist im IR-Spektrum keine Hydroxyl- und keine Carbonylbande auf, dafür taucht die charackteristische Enolätherbande auf. Im NMR-Spektrum findet man die in der Tabelle 4 angegebenen charakteristischen Signale für vinylische Protonen. Zur weiteren Charakterisierung sind die Molpeaks im Massenspektrum angegeben.

TABELLE 4

Verbindungen der allgemeinen Formel II
($R_2$=$R_5$=$R_6$=$R_7$=$R_8$=$R_{10}$=H); $R_2'$= O–

| Verbin-dung Nr. | n | $R_1$ | $R_9$ | NMR Vinyl-protonen δ (ppm) ($CDCl_3$) | IR ($cm^{-1}$) ($CH_2Cl_2$) | MS ($M^+$) | Ausbeute (% d.Th.) |
|---|---|---|---|---|---|---|---|
| 25 | 2 | $(-CH_2)_2-O-(CH_2-)_2$ | Phenyl | 5,55 | 1 635 | 514 | 39 |
| 26 | 2 | $(-CH_2)_4-$ | H | 5,53 | 1 635 | 346 | 47 |
| 27 | 1 | $(-CH_2)_7-CH_3$ | H | 5,43 | 1 635 | 258 | 45 |
| 28 | 2 | $(-CH_2)_3-$ | H | 5,50 | 1 635 | 332 | 39 |
| 29 | 2 | $(-CH_2)_2-O-(CH_2-)_2$ | H | 5,50 | 1 635 | 362 | 48 |
| 30 | 2 | $(-CH_2)_2(-OCH_2CH_2)_2-$ | H | 5,47 | 1 635 | 406 | 43 |

TABELLE 5

Verbindungen der allgemeinen Formel I
n = 2; $R_1$ = $(-CH_2)_2-O-(CH_2-)_2$

| Verbindung Nr. | 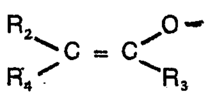 | NMR Vinyl-protonen δ (ppm) ($CDCl_3$) | IR ($cm^{-1}$) ($CH_2Cl_2$) | MS ($M^+$) | Ausbeute (% d.Th.) |
|---|---|---|---|---|---|
| 31 | 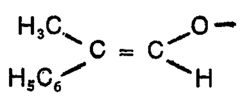 | 6,32 / 6,04 | 1 645 | 338 | 54 |
| 32 | 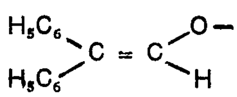 | 6,41 | 1 625 | 462 | 60 |
| 33 | 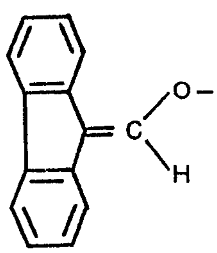 | – | 1 650 | 458 | 23 |

Allgemeine Vorschrift C

*Herstellung der in Tabelle 6 aufgeführten Verbindungen 34 bis 36*

1 Mol Methyl- bzw. Äthyl-Enoläther wird in Gegenwart von 1 Gewichts prozent eines sauren Katalysators, z. B. Kaliumhydrogensulfat, mit einem Mol eines einwertigen aliphatischen Alkohols versetzt und 1 Stunde bei Raumtemperatur gerührt. Nach Zugabe von 0,5 Gewichtsprozent 85%iger Phosphorsäure und 1,2 Gewichtsprozent Pyridin zu dem als Zwischenprodukt entstandenen gemischten Acetal bzw. Ketal wird das Gemisch zum Sieden erhitzt. Der bei der Reaktion langsam gebildete leichtflüchtige Alkohol wird im Vakuum entfernt. Nach Beendigung der Alkoholabspaltung wird der Kolbeninhalt destilliert. Die Ausbeuten der Enoläther sind nicht optimiert. Zur Charakterisierung sind die Signale der vinylischen Protonen im NMR-Spektrum, die Enolätherbanden im IR-Spektrum und die Molpeaks im Massenspektrum angegeben.

TABELLE 6

Verbindungen der allgemeinen Formel I

$n = 1;\ R_1=(-CH_2)_2(-OCH_2CH_2)_2-O-C_4H_9$

| Verbindung Nr. | $R_2$ | $R_3$ | $R_4$ | NMR Vinylprotonen δ (ppm) ($CDCl_3$) | IR ($cm^{-1}$) ($CH_2Cl_2$) | MS ($M^+$) | Ausbeute (% d.Th.) |
|---|---|---|---|---|---|---|---|
| 34 | H | $(-CH_2)_4-$ | | 4,65 | 1 660 | 286 | 39 |
| 35 | Äthyl | Propyl | H | 4,33 | 1 660 | 302 | 39 |
| 36 | H | Methyl | Phenyl | 5,65<br>5,42 | 1 645 | 322 | 37 |

Beispiel 1

Eine Offset-Druckform wird in folgender Weise hergestellt:

Mit einer Beschichtungslösung, bestehend aus

94,6 Gt Methyläthylketon,
4,0 Gt Kresol-Formaldehyd-Novolak (Schmelzpunkt nach Kapillar-Methode DIN 53 181: 105—120°C),
1,2 Gt Verbindung 30,
0,.2 Gt 2-(4,7-Dimethoxy-naphth-1-yl)-4,6-bis-trichlormethyl-s-triazin und
0,01 Gt Kristallviolett

beschichtet man eine elektrolytisch aufgerauhte und anodisierte Aluminium-Folie auf einer Schleuder (150 U/min), wobei sich ein Trockenschichtgewicht von ca. 1,5—2,0 g/m² ergibt. Das ausreichend getrocknete lichtempfindliche Material wird unter einer positiven Strich- und Raster-Vorlage mit einer 5 kW Metall-Halogenidlampe im Abstand von 110 cm 20 Sekunden belichtet, wonach ein starker blaugrüner Bildkontrast zu sehen ist. Entwickelt wird mit der folgenden Entwicklerlösung:

5,5% Natrium-metasilikat × $5H_2O$,
3,4% Trinatriumphosphat × 12 $H_2O$,
0,4% Natriumdihydrogenphosphat, wasserfrei,
90,7% vollentsalztes Wasser.

Innerhalb von 40 Sekunden werden die belichteten Schichtpartien entfernt, und die blaugefärbten unbelichteten Schichtteile bleiben als Druckschablone stehen. Die so hergestellte Offsetdruckform wird wie üblich mit fetter Farbe eingefärbt und in die Druckmaschine gespannt. Zur Lagerung kann die Platte mit handelsüblichen Konservierungsmitteln überwischt werden. Nach 50 000 Drucken wird der Druckversuch bei noch intakter Druckform abgebrochen. Die erreichbare hohe Druckauflage kann durch Nacherhitzen der entwickelten Druckform auf ca. 230—240°C noch deutlich gesteigert werden.

Ein ähnliches Ergebnis wird erhalten, wenn die Verbindung 30 durch gleiche Gewichtsmengen der Verbindung 28 ersetzt wird.

Beispiele 2 und 3

Auf drahtgebürstete Aluminiumfolie werden ca. 2 µm dicke Schichten der Zusammensetzung

74% Novolak nach Beispiel 1,
22% Verbindung 29,
3,8% Säurespender und
0,2% Kristallviolett

aufgebracht. Die erhaltenen Druckplatten werden mit 11 kV-Elektronen bestrahlt. Beim Tauchen in den im Beispiel 1 genannten Entwickler werden die bestrahlten Bereiche unter den in der Tabelle 7 aufgeführten Bedingungen herausgelöst.

TABELLE 7

| Beispiel | Säurespender | eingestrahlte Energie (Joule/cm²) | Entwicklungszeit (s) |
|---|---|---|---|
| 2 | 2-(4-Äthoxy-naphth-1-yl)-4,6-bis-trichlormethyl-s-triazin | $5 - 50 \cdot 10^{-2}$ | 60 |
| 3 | Chlorparaffinharz | $8 - 150 \cdot 10^{-2}$ | 30 |

Die Schicht aus Beispiel 3 erweist sich als praktisch unempfindlich gegenüber Bestrahlung mit üblicherweise in der Technik verwendeten Lichtquellen.

Beispiel 4

Die Stabilität bei thermischer Belastung der die säurespaltbaren Enoläther enthaltenden Schichten zeigt das folgende Beispiel:

Eine Beschichtungslösung entsprechend Beispiel 1 wird auf gebürstete Aluminiumfolie so aufgeschleudert, daß die getrocknete Schicht ca. 1,5 µm dick ist.

Dieses Material wird in einem Trockenschrank 1 Stunde auf 100°C erhitzt, 15 Sekunden unter den in Beispiel 1 genannten Bedingungen belichtet und in 2 Minuten durch Schwenken in dem Entwickler von Beispiel 1 zu einem positiven Abbild der Vorlage entwickelt, das sich als Offset-Druckform eignet.

Bei Verwendung eines Phenol-Formaldehyd-Novolaks mit dem Schmelzbereich 110—120°C nach DIN 53 181 anstelle des in Beispiel 1 genannten Novolaks wird die Entwicklungszeit reduziert, bei Verwendung von elektrolytisch aufgerauhtem und anodisiertem Aluminium als Trägermaterial auf 3 Minuten verlängert.

Beispiel 5

Aluminiumplatten werden mit einer Lösung aus

4,7 Gt Novolak nach Beispiel 1,
1,4 Gt Verbindung 29,
0,23 Gt Säurespender und
0,02 Gt Kristallviolett-Base in
93,65 Gt Butan-2-on

schleuderbeschichtet, so daß nach dem Trocknen eine Schichtdicke von etwa 1,7 µm resultiert. Diese Schichten werden mit einem Argon-Ionen-Laser von 10 bzw. 25 W Lichtleistung über alle Spektrallinien bildmäßig bestrahlt, wobei der Lasterstrahl auf einen Fleck mit 5 µm Durchmesser focussiert wird. Durch Variation der Lichtleistung und der Schreibgeschwindigkeit werden die Empfindlichkeiten der Schichten ermittelt. Die belichteten Schichtteile lassen sich durch Behandeln mit dem Entwickler aus Beispiel 1 herauslösen, und die Laserspur wird durch Einfärben der unbestrahlten Bereiche mit fetter Farbe noch deutlicher hervorgehoben:

TABELLE 8

| Laser-leistung | Säurespender | Al-Oberfläche | Entwick-lung (s) | max. Schreib-geschwindig-keit (m/s) |
|---|---|---|---|---|
| 25 W | 2-(4-Äthoxy-naphth-1-yl)-4,6-bis-trichlormethyl-s-triazin | drahtgebürstet | 70 | 60 |
| 25 W | ,, | elektrolytisch aufgerauht und anodisiert | 60 | 100 |
| 10 W | 2,5-Diäthoxy-4-p-tolyl-mercapto-benzol-diazonium-hexa-fluorophosphat | ,, | 35 | 100 |
| 10 W | ,, | drahtgebürstet | 35 | 100 |

Mit ähnlichem Ergebnis kann das genannte Diazoniumsalz durch die gleiche Gewichtsmenge 2,5-Diäthoxy-4-benzoylamino-benzoldiazoniumhexa-fluorophosphat ersetzt werden.

Beispiel 6

Platten aus gebürstetem Aluminium werden durch Tauchen in Lösungen von

10,64 Gt Novolak nach Beispiel 1,
3,20 Gt Enoläther und
0,16 Gt 2-[4-(2-Äthoxy-äthoxy)-naphth-1-yl]-4,6-bis-trichlormethyl-s-triazin in
86,0 Gt Methyläthylketon

beschichtet, nach dem Herausziehen und Abdunsten des Lösungsmittels 20 Sekunden in einem warmen Luftstrom getrocknet und durch eine Strickvorlage, die von einer 1 mm starken Glasplatte bedeckt ist, belichtet. Das Belichtungsgerät ist mit vier Leuchtstoffröhren von 40 W im Abstand von 4 cm bestückt. Die Entfernung der Röhrenperipherie von der Plattenoberfläche beträgt ca. 5 cm. Die Belichtungszeiten sind bei Verwendung der einzelnen Enoläther der Tabelle 9 zu entnehmen. Die Entwicklung zu einem positiven Abbild der Vorlage erfolgt durch Schwenken in dem Entwickler aus Beispiel 1.

TABELLE 9

| Verbindung | Belichtungszeit (Sekunden) | Verbindung | Belichtungszeit (Sekunden) |
|---|---|---|---|
| 1 | 10 | 19 | 5 |
| 2 | 11 | 20 | 10 |
| 3 | 8 | 21 | 10 |
| 4 | 3 | 22 | 10 |
| 5 | 4 | 23 | 15 |
| 6 | 20 | 24 | 11 |
| 7 | 8 | 25 | 20 |
| 8 | 13 | 26 | 10 |
| 9 | 13 | 27 | 11 |
| 10 | 30 | 28 | 15 |
| 11 | 2 | 29 | 14 |
| 12 | 10 | 30 | 15 |
| 13 | 15 | 31 | 30 |
| 14 | 4 | 32 | 25 |
| 15 | 10 | 33 | 15 |
| 16 | 10 | 34 | 13 |
| 17 | 1 | 35 | 3 |
| 18 | 3 | 36 | 6 |

**Patentansprüche**

1. Strahlungsempfindliches Gemisch, das (a) eine unter Einwirkung von aktinischer Strahlung Säure bildende Verbindung und (b) eine Verbindung enthält, die mindestens eine durch Säure spaltbare C—O—C-Gruppe aufweist und deren Löslichkeit in einem flüssigen Entwickler durch Einwirkung von Säure erhöht wird, dadurch gekennzeichnet, daß die durch Säure spaltbare Verbindung als säurespaltbare Gruppe wenigstens eine Enoläthergruppe enthält.

2. Strahlungsempfindliches Gemisch nach Anspruch 1, dadurch gekennzeichnet, daß die durch Säure spaltbare Verbindung (b) der allgemeinen Formel I

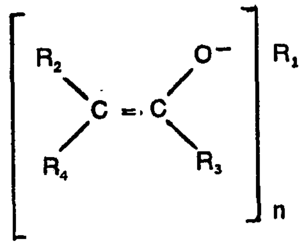

(I)

entspricht, in der

$R_1$ einen n-wertigen aliphatischen Rest mit wenigstens 2 Kohlenstoffatomen bedeutet, $R_2$, $R_3$ und $R_4$ gleich oder verschieden sind und Wasserstoffatome, Alkyl- oder Arylreste bedeuten oder jeweils zu zweit zu einem gesättigten oder olefinisch ungesättigten Ring verbunden sind, und n eine ganze Zahl von 1 bis 4 ist.

3. Strahlungsempfindliches Gemisch nach Anspruch 2, dadurch gekennzeichnet, daß die durch Säure spaltbare Verbindung der allgemeinen Formel II

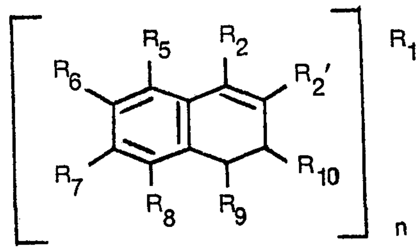

(II)

entspricht, in der

$R_1$ einen n-wertigen aliphatischen Rest mit wenigstens zwei Kohlenstoffatomen, $R_2$ und $R_2'$ voneinander verschiedene Reste bedeuten, wobei der eine Reste die Gruppe —O— und der andere ein Wasserstoffatom, einen Alkyl- oder Arylrest bedeutet, $R_5$ bis $R_{10}$ gleich oder verschieden sind und Wasserstoff- oder Halogenatome, Alkyl-, Aryl- oder Alkoxyreste bedeuten und n eine ganze Zahl von 1 bis 4 ist.

4. Strahlungsempfindliches Gemisch nach Anspruch 2 oder 3, dadurch gekennzeichnet, daß n 1 oder 2 ist.

5. Strahlungsempfindliches Gemisch nach Anspruch 3, dadurch gekennzeichnet, daß $R_2' =$ —O— ist.

6. Strahlungsempfindliches Gemisch nach Anspruch 1, dadurch gekennzeichnet, daß die Säure spaltbare Verbindung ein Molekulargewicht von 250 bis 800 hat.

7. Strahlungsempfindliches Gemisch nach Anspruch 1, dadurch gekennzeichnet, daß es zusätzlich ein polymeres wasserunlösliches Bindemittel enthält.

8. Verfahren zur Herstellung von Reliefbildern, bei dem man ein strahlungsempfindliches Aufzeichnungsmaterial aus einem Schichtträger und einer Aufzeichnungsschicht, die (a) eine unter Einwirkung von aktinischer Strahlung Säure bildende Verbindung und (b) eine Verbindung enthält, die mindestens eine durch Säure spaltbare C—O—C-Gruppe aufweist und deren Löslichkeit in einem flüssigen Entwickler durch Einwirkung von Säure erhöht wird, bildmäßig mit aktinischer Strahlung in solcher Dosis bestrahlt, daß die Löslichkeit der Schicht in einem flüssigen Entwickler zunimmt, und die bestrahlten Schichtteile mittels eines Entwicklers entfernt, dadurch gekennzeichnet, daß man eine Verbindung (b) verwendet, die als säurespaltbare Gruppe wenigstens eine Enoläthergruppe enthält.

**Claims**

1. A radiation-sensitive mixture containing (a) a compound which forms an acid under the influence of actinic radiation and (b) a compound which has at least one acid-cleavable C—O—C group and the solubility of which in a liquid developer is increased by the action of an acid, characterized in that the compound which is capable of being cleft by an acid contains as the acid-cleavable group at least one enol ether group.

2. A radiation-sensitive mixture according to claim 1, characterized in that the compound (b) which is capable of being cleft by an acid corresponds to the general formula I

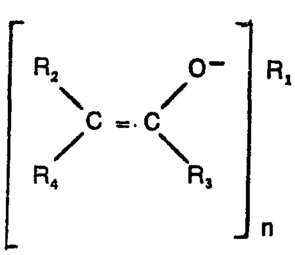

(I)

wherein

$R^1$ stands for a n-valent aliphatic radical which has at least 2 carbon atoms, $R_2$, $R_3$ and $R_4$ are identical or different and stand for hydrogen atoms, alkyl or aryl radicals or any two thereof are linked to

form a saturated or olifinically unsaturated ring, and n is an integer from 1 to 4.

3. A radiation-sensitive mixture according to claim 2, characterized in that the compound which is capable of being cleft by an acid corresponds to the general formula II

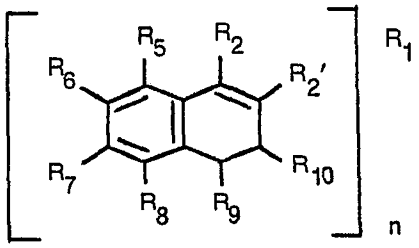

(II)

wherein

$R_1$ stands for a n-valent aliphatic radical which has at least 2 carbon atoms, $R_2$ and $R_2'$ stand for radicals which differ from each other, one of the radicals representing the —O— group and the other a hydrogen atom, an alkyl or aryl radical, $R_5$ to $R_{10}$ are identical or different and stand for hydrogen atoms or halogen atoms, alkyl, aryl or alkoxy radicals, and n is an integer from 1 to 4.

4. A radiation-sensitive mixture according to claim 2 or claim 3, characterized in that n is 1 or 2.

5. A radiation-sensitive mixture according to claim 3, characterized in that $R_2'$ is —O—.

6. A radiation-sensitive mixture according to claim 1, characterized in that the compound which is capable of being cleft by an acid has a molecular weight ranging between 250 and 800.

7. A radiation-sensitive mixture according to claim 1, characterized in that it additionally contains a polymeric water-insoluble binder.

8. A process for producing relief images in which a radiation-sensitive recording material which comprises a support and a recording layer containing (a) a compound forming an acid under the influence of actinic radiation and (b) a compound which has at least one acid-cleavable C—O—C group and the solubility of which in a liquid developer is increased by the action of an acid, is imagewise irradiated with actinic radiation of such a dosage that the solubility of the layer in a liquid developer is increased, and the irradiated layer areas are removed with the aid of a developer, characterized in that a compound (b) is used which contains as the acid-cleavable group at least one enol ether group.

**Revendications**

1. Mélange sensible au rayonnement contenant (a) un composé formant de l'acide sous l'action d'un rayonnement actinique et (b) un composé présentant au moins un groupe C—O—C dissociable par un acide et dont la solubilité dans un révélateur liquide est augmentée par l'action d'un acide, caractérisé en ce que le composé dissociable par un acide comprend en tant que groupe dissociable par l'acide au moins un groupe éther énolique.

2. Mélange sensible au rayonnement selon la revendication 1, caractérisé en ce que le composé (b) dissociable par un acide répond à la formule générale I

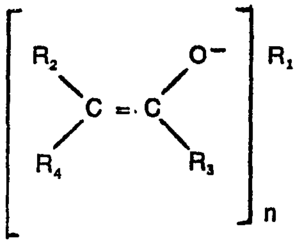

(I)

dans laquelle:

$R_1$ est un reste aliphatique à n valences ayant au moins 2 atomes de carbone, $R_2$, $R_3$ et $R_4$ sont identiques ou différents et sont des atomes d'hydrogène, des restes alkyle ou aryle, ou deux de ces substituants forment chaque fois ensemble un cycle saturé ou insaturé de manière oléfinique, et n est un nombre entier entre 1 et 4.

3. Mélange sensible au rayonnement selon la revendication 2, caractérisé en ce que le composé dissociable par l'acide répond à la formule générale II.

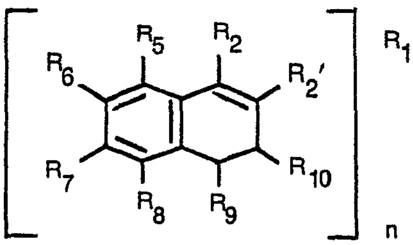

(II)

dans laquelle

$R_1$ est un reste aliphatique à n valences ayant au moins deux atomes de carbone, $R_2$ et $R_2'$ sont des restes différents entre eux, l'un des restes étant le groupe —O— et l'autre un atome d'hydrogène, un rest alkyle ou aryle, $R_5$ à $R_{10}$ sont identiques ou différents et sont des atomes d'hydrogène ou d'halogène, des restes alkyle, aryle ou alcoxy, et n est un nombre entier entre 1 et 4.

4. Mélange sensible au rayonnement selon la revendication 2 ou 3, caractérisé en ce que n est égal à 1 ou 2.

5. Mélange sensible au rayonnement selon la revendication 3 caractérisé en ce que $R_2' =$ —O—.

6. Mélange sensible au rayonnement selon la revendication 1, caractérisé en ce que le composé dissociable par un acide a un poids moléculaire compris entre 250 et 800.

7. Mélange sensible au rayonnement selon la revendication 1, caractérisé en ce qu'il contient additionnellement un liant polymère insoluble dans l'eau.

8. Procédé pour l'obtention d'images en relief, dans lequel une matière d'enregistrement sensible au rayonnement, comprenant un support de couche et une couche d'enregistrement renfermant (a) un composé formant de l'acide sous l'action d'un rayonnement actinique et (b) un composé présentant au moins un groupe C—O—C dissociable par un acide et dont la solubilité dans un révélateur liquide est augmentée par l'action d'un acide, est irradiée selon une image par un rayonnement actinique en une dose telle que la solubilité de la couche dans un révélateur liquide augmente, et les plages exposées de la couche sont éliminées au moyen d'un révélateur, caractérisé en ce que l'on utilise un composé (b) renfermant comme groupe dissociable par un acide, au moins un groupe éther énolique.